# FASCICULE DE BREVET EUROPEEN

(11) **EP 0 564 377 B1**
(45) Date de publication et mention de la délivrance du brevet: **26.07.1995**
(21) Numéro de dépôt: 93420134.4
(22) Date de dépôt: 25.03.1993
(51) Int. Cl.: H03L 7/089, H03L 7/099

(54) **Boucle à verrouillage de fréquence**
Frequenzregelschleife
Frequency locked loop

(30) Priorité: 31.03.1992 FR 9204261
(43) Date de publication de la demande: 06.10.1993
(73) Titulaire: SGS-THOMSON MICROELECTRONICS S.A., 94250 Gentilly (FR)
(72) Inventeur: Debaty, Pascal, F-38420 Domene (FR)
(74) Mandataire: de Beaumont, Michel

(56) Documents cités:
- FR-A- 2 564 664
- US-A- 4 577 163
- US-A- 5 075 640
- TRANSACTIONS OF THE INSTITUTE OF ELECTRONICS AND COMMUNICATION ENGINEERS OF JAPAN, SECTION E vol. E63, no. 5, Mai 1980, TOKYO JP pages 367 - 368 TAIICHIRO KURITA ET AL. 'A Digital Phase-Locked Loop with AND Filter'

## Description

La présente invention concerne les boucles à verrouillage de phase et plus particulièrement celles comprenant un comparateur de phase à deux entrées et deux sorties, la première sortie fournissant un signal quand la première entrée est en avance sur la seconde et la deuxième sortie fournissant un signal quand la deuxième entrée est en avance sur la première.

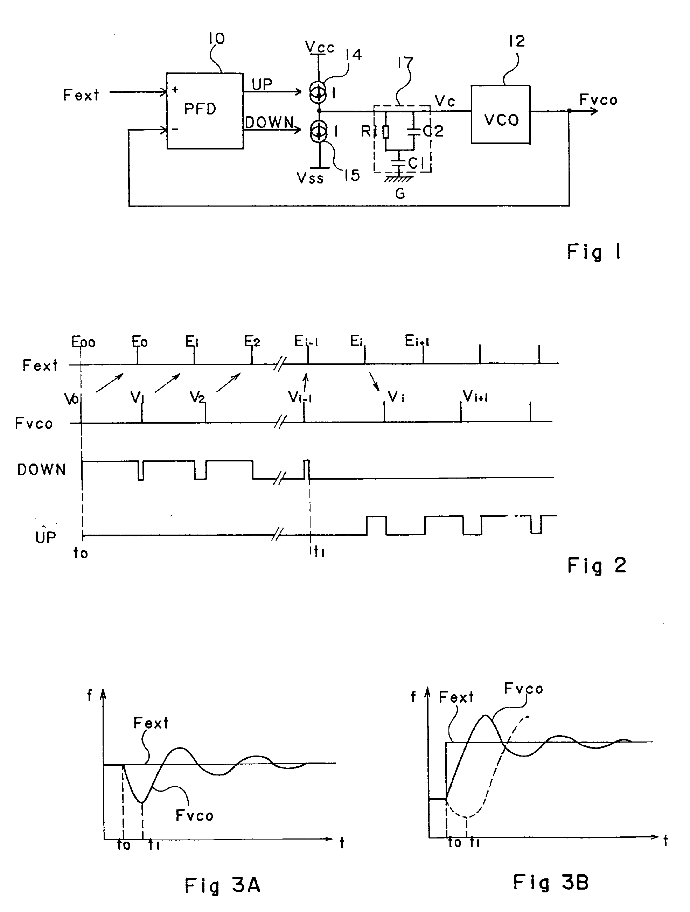

La figure 1 représente un schéma simplifié d'un exemple de boucle à verrouillage de phase classique dit à "pompe de charge".

Un comparateur de phase (PFD) 10 reçoit sur une première entrée un signal logique Fext et sur une deuxième entrée un signal logique Fvco fourni par un oscillateur commandé en tension (VCO) 12. Ce comparateur est généralement sensible aux fronts descendants des signaux Fext et Fvco. Une pompe de charge comprend deux sources de courant 14, 15 de même valeur I, destinées à charger ou décharger des capacités faisant éventuellement partie d'un filtre 17. Les sources 14 et 15 sont disposées en série entre un potentiel haut Vcc et un potentiel bas Vss et sont respectivement pilotées par une sortie UP et une sortie DOWN du comparateur de phase 10. Le point de connexion entre les sources 14 et 15 est relié à l'entrée de commande de l'oscillateur 12 et au filtre 17 qui est relié à un potentiel de référence G, tel que la masse. Le filtre 17 comprend généralement une capacité d'intégration C1 disposée en série avec une cellule de correction comprenant une résistance R et une capacité C2 reliées en parallèle.

La sortie UP du comparateur de phase 10 délivre des impulsions (impulsions UP) de durée égale à l'avance de phase du signal Fext par rapport au signal Fvco. La sortie DOWN délivre des impulsions (impulsions DOWN) de durée égale au retard de phase du signal Fext par rapport au signal Fvco. Ainsi, les capacités du filtre 17, notamment la capacité C1 qui est de grande valeur par rapport à la capacité C2, sont progressivement chargés ou déchargées selon la relation de phase entre les signaux Fext et Fvco. La tension Vc aux bornes du filtre 17, qui varie en fonction de cette relation de phase, corrige la fréquence de l'oscillateur 12 dans le but de rattraper l'erreur de phase du signal Fvco. La cellule de correction R, C2 sert, lors de chaque front montant d'une impulsion UP ou DOWN, à fournir un pic de tension pour brièvement sur-corriger l'oscillateur 12.

La figure 2 représente des signaux Fext, Fvco, UP et DOWN correspondant à un exemple de situation. Pour simplifier la compréhension des figures, les signaux Fext et Fvco ont été représentés sous la forme d'impulsions de durée pratiquement nulle. Le signal Fext est représenté à une fréquence constante. Chaque impulsion du signal Fext est notée Eₙ et l'impulsion correspondante du signal Fvco est noté Vₙ, l'indice n étant un entier représentant le rang de l'impulsion.

A un instant t₀, une impulsion V₀ du signal Fvco arrive avant l'impulsion correspondante E₀ du signal Fext. Le comparateur 10 détecte alors une avance de phase du signal Fvco par rapport au signal Fext et fournit une impulsion DOWN active de l'impulsion V₀ jusqu'à l'impulsion E₀, ce qui entraîne une diminution de la fréquence du signal Fvco. L'impulsion suivante V₁ est toujours en avance par rapport à l'impulsion E₁ et il survient une nouvelle impulsion DOWN entraînant une nouvelle diminution de la fréquence du signal Fvco... Cette première phase de fourniture d'impulsions DOWN se poursuit jusqu'à ce que l'on arrive sensiblement à une coïncidence de phase entre des impulsions Eᵢ₋₁ et Vᵢ₋₁ à un instant t₁.

Ensuite commence une deuxième phase de fourniture d'impulsions UP. A partir des impulsions Eᵢ et Vᵢ, on se trouve dans une situation où le signal Fvco est en retard de phase par rapport au signal Fext. La boucle à verrouillage de phase tend à compenser ce retard de phase en augmentant la fréquence du signal Fvco par des impulsions UP... jusqu'à ce que le signal Fvco soit de nouveau en avance de phase par rapport au signal Fext.

Les deux phases précédentes se produisent de façon alternée jusqu'à ce que les signaux Fext et Fvco soient synchronisés. En attendant la synchronisation, la fréquence du signal Fvco oscille autour de celle du signal Fext.

La figure 3A représente l'allure de la variation de fréquence du signal Fvco dans le cas d'un glissement de phase du signal Fext alors que les signaux Fext et Fvco sont initialement synchronisés. Cette situation correspond par exemple à celle de la figure 2 et elle peut être due à une impulsion manquante du signal Fext, désignée E₀₀ à la figure 2. Dans le cas d'une impulsion E manquante, la boucle à verrouillage de phase interprète la situation comme si le signal Fvco se trouvait en avance de phase d'une période.

A l'instant t₀ survient le glissement de phase du signal Fext. A partir de l'instant t₀, la fréquence du signal Fvco se met à osciller autour de la fréquence du signal Fext et tend lentement vers celle-ci. Les instants t₀ et t₁ correspondent à ceux de la figure 2.

La figure 3B illustre l'allure de la fréquence du signal Fvco lorsque la fréquence du signal Fext glisse à un instant t₀ vers une valeur supérieure. A partir de l'instant t₀, la fréquence du signal Fvco croît, dépasse la nouvelle fréquence du signal Fext, oscille autour de la nouvelle fréquence et tend lentement vers la nouvelle fréquence.

Si dans la figure 3B l'instant t₀ correspond à un démarrage de la boucle, on peut se trouver dans la situation de la figure 2, c'est-à-dire que le signal Fvco est en avance de phase par rapport au signal Fext mais est à une fréquence inférieure. Alors, comme cela est représenté en pointillés, la fréquence du signal Fvco commence même par décroître, c'est-à-dire varie dans le sens opposé du sens souhaité.

On constate que la boucle à verrouillage de phase tend rapidement à rattraper l'erreur de phase entre les signaux Fext et Fvco par une modification de la fréquence du signal Fvco à chaque impulsion, ce qui a pour inconvénient d'entraîner une oscillation de la fréquence du signal Fvco. Cette oscillation dure d'autant plus longtemps et est d'amplitude d'autant plus grande que l'erreur de phase initiale est importante. Un glissement de phase ou une impulsion manquante perturbe notablement la boucle, même si les signaux Fext et Fvco sont synchronisés.

Il se peut parfois que la fréquence du signal Fvco ne converge même pas vers celle du signal Fext lors d'une perturbation particulière ou si certains composants sont mal choisis. Les composants du filtre 17 doivent être soigneusement choisis pour réaliser un compromis entre la stabilité et la rapidité de synchronisation.

Un autre inconvénient des boucles à verrouillage du type de la figure 1 est que les capacités, notamment la capacité C₁, et la résistance R du filtre 17 sont généralement de grandes valeurs et doivent être prévues à l'extérieur d'un circuit intégré comprenant les autres éléments de la boucle à verrouillage de phase.

Le brevet américain 4 577 163 décrit une boucle à verrouillage de phase numérique comprenant un synthétiseur de fréquence commandé par un compteur qui est incrémenté par un comparateur de phase lorsque la sortie du synthétiseur est en retard de phase par rapport à un signal d'entrée, et qui est décrémenté dans le cas contraire.

La demande de brevet Français 2 564 664 décrit une boucle à verrouillage de phase qui opère une moyenne d'écart de phase sur un nombre N d'impulsions délivrées par un comparateur de phase et qui corrige ensuite l'oscillateur une fois sur N en fonction de cette moyenne.

Un objet de la présente invention est de prévoir une boucle à verrouillage de fréquence peu sensible à une perturbation de phase.

Un autre objet de la présente invention est de prévoir une telle boucle à verrouillage de fréquence qui converge de façon monotone en fréquence.

Un autre objet de la présente invention est de prévoir une telle boucle à verrouillage de fréquence qui ne nécessite aucun réglage.

Un autre objet de la présente invention est de prévoir une telle boucle à verrouillage de fréquence qui soit en outre entièrement intégrable.

Ces objets sont atteints dans une boucle à verrouillage de fréquence selon la revendication 1 grâce à un circuit utilisant un comparateur de phase du type susmentionné mais dont l'indication d'erreur de phase est échantillonnée avant de modifier la fréquence d'un oscillateur commandé. La période d'échantillonnage est choisie de manière que chaque échantillon indique non seulement une relation de phase entre les signaux d'entrée du comparateur de phase, mais aussi de façon sûre dans quel sens doit varier la fréquence de l'oscillateur pour tendre rapidement vers une synchronisation en fréquenoe des signaux d'entrée.

La présente invention vise plus particulièrement une boucle à verrouillage de fréquence comprenant : un comparateur de phase recevant en entrée des premier et deuxième signaux périodiques et délivrant, au moins à chaque période du premier ou deuxième signal, un signal d'erreur de phase représentatif de la différence de phase entre les signaux d'entrée ; et un oscillateur délivrant le deuxième signal et commandé par un circuit de traitement du signal d'erreur de phase. Selon l'invention, la boucle comprend un circuit d'échantillonnage disposé entre le comparateur et le circuit de traitement pour fournir au circuit de traitement le signal d'erreur de phase seulement à chaque N^{ème} période (N>1) du premier ou deuxième signal.

Le comparateur de phase comprend une première sortie délivrant des impulsions si le premier signal est en avance de phase par rapport au deuxième et une deuxième sortie délivrant des impulsions dans le cas inverse et le circuit d'échantillonnage fournit au circuit de traitement chaque N^{ème} desdites impulsions.

Le circuit de traitement comprend un compteur dont l'état fixe la fréquence de l'oscillateur et possédant une entrée d'incrémentation et une entrée de décrémentation, et le circuit d'échantillonnage comprend des moyens pour transmettre chaque dite N^{ème} impulsion, soit vers l'entrée d'incrémentation si cette impulsion survient sur l'une des première et deuxième sorties du comparateur, soit vers l'entrée de décrémentation si cette impulsion survient sur l'autre des première et deuxième sorties.

Selon un mode de réalisation de la présente invention, la fréquence de l'oscillateur est variable par pas fréquentiels et le nombre N est choisi supérieur au rapport entre la fréquence nominale du premier signal et un pas fréquentiel.

Selon un mode de réalisation de la présente invention, la boucle comprend un diviseur par N recevant en entrée lesdites impulsions et commandant par sa sortie deux portes logiques dont les sorties sont respectivement reliées aux entrées d'incrémentation et de décrémentation du compteur et recevant respectivement les impulsions de l'une et l'autre des première et deuxième sorties du comparateur.

Selon un mode de réalisation de la présente invention, lesdites portes sont reliées au comparateur de phase par l'intermédiaire de bascules monostables.

Selon un mode de réalisation de la présente invention, le diviseur est un diviseur par un nombre N programmable.

Selon un mode de réalisation de la présente invention, l'oscillateur est un oscillateur à réseau de capacités dont chacune est mise hors ou en circuit par l'état d'un bit du compteur.

Ces objets, caractéristiques, et avantages ainsi que d'autres de la présente invention seront exposés en détail dans la description suivante de modes de réalisation particuliers faite en relation avec les figures jointes parmi lesquelles :
la figure 1, précédemment décrite, illustre une boucle à verrouillage de phase à pompe de charge classique ;
la figure 2 illustre des allures de signaux en divers points du circuit de la figure 1 ;
les figures 3A et 3B représentent les allures des réponses du circuit de la figure 1 à diverses perturbations ;
la figure 4 illustre des allures de signaux dans une situation où on n'agit pas sur ces signaux ;
la figure 5 illustre un mode de réalisation de boucle à verrouillage de fréquence selon la présente invention ; et
la figure 6 représente l'allure de la réponse du circuit de la figure 5 à un échelon de fréquence.

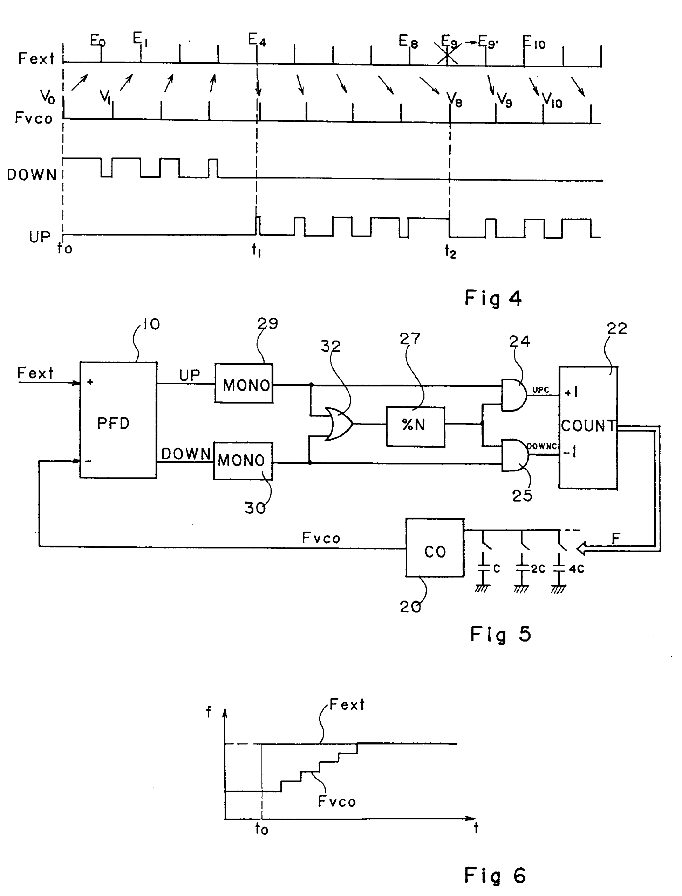

La présente invention se base sur la constatation du fait que, dans une boucle à verrouillage de phase classique, il n'existe à un instant donné, pour les deux signaux à synchroniser, aucune corrélation entre une erreur de phase et une erreur de fréquence, comme le montre la figure 2 à l'instant t₀. Par contre, la demanderesse a noté que, si on observe les signaux à synchroniser pendant un intervalle de temps suffisamment long, à la fin de cet intervalle, l'erreur de phase entre ces signaux indique effectivement une erreur de fréquence, comme le montre la figure 4 ci-après à partir d'un instant t₁. La présente invention a pour but d'échantillonner l'erreur de phase à des instants où celle-ci indique une erreur de fréquence pour alors corriger cette erreur de fréquence.

Dans la figure 4, on examine les signaux de sortie d'un comparateur de phase du type de celui de la figure 1 dans une situation particulière où l'on n'agit pas sur le signal Fvco. Les mêmes notations que dans la figure 2 sont utilisées. Le signal Fext est représenté à une fréquence constante et le signal Fvco est représenté à une fréquence constante inférieure.

A un instant t₀ une impulsion V₀ du signal Fvco survient avant l'impulsion correspondante E₀ du signal Fext. La fréquence du signal Fvco étant constante et inférieure à celle du signal Fext, cette avance de phase du signal Fvco est progressivement rattrapée, comme le montrent les impulsions DOWN de largeurs décroissantes. A un instant t₁, on arrive à une situation où le signal Fvco est en retard de phase. Alors, le retard de phase croît progressivement, comme le montrent les impulsions UP de largeurs croissantes. En principe, les largeurs des impulsions UP croîtraient vers l'infini.

En pratique, on arrive à une situation représentée autour d'un instant t₂. Juste avant l'instant t₂, une impulsion E₈ arrive avant une impulsion correspondante V₈. Une impulsion UP survient normalement entre les impulsions E₈ et V₈. Or, l'instant t₂ où survient l'impulsion V₈ est ultérieur à l'instant où survient l'impulsion E₉, c'est-à-dire qu'à l'instant t₂ le signal Fvco est en retard de phase par rapport au signal Fext de plus de 360°.

Un comparateur de phase du type de celui de la figure 1 est tel que, lorsque l'une de ses sorties a été rendue active par une impulsion sur l'une quelconque de ses entrées, le comparateur est insensible à toute autre impulsion sur cette entrée tant qu'une impulsion sur son autre entrée ne désactive pas la sortie du comparateur. Ainsi, dans la figure 4, l'impulsion E₉ du signal Fext est ignorée et c'est l'impulsion suivante E′₉ qui est " considérée " comme l'impulsion E₉. Comme cela est représenté par une impulsion UP courte correspondant aux impulsions E′₉ et V₉, le fait d'ignorer une impulsion du signal Fext est interprété comme une réduction de l'erreur de phase, cette erreur de phase gardant le même signe.

Ainsi, si l'on n'agit pas sur la fréquence du signal Fvco, quelles que soient les conditions initiales, le comparateur de phase fournira, au bout d'un certain temps (à partir de t₁ à la figure 4), des impulsions toujours indicatives du signe de la relation de fréquence entre les signaux Fext et Fvco.

La figure 5 représente un mode de réalisation entièrement intégrable d'une boucle à verrouillage de fréquence selon l'invention. On retrouve le comparateur de phase 10 de la figure 1 recevant en entré un signal externe Fext et un signal Fvco provenant d'un oscillateur commandé 20 et délivrant des impulsions UP ou DOWN en fonction de la relation de phase entre les signaux Fext et Fvco. Selon l'invention, la fréquence de l'oscillateur 20 est déterminée par une consigne F qui n'est modifiée que toutes les N impulsions UP ou DOWN.

Dans le mode de réalisation de la figure 5, l'oscillateur 20 est un oscillateur classique oscillant autour d'une valeur de repos qui peut être modifiée par un réseau de capacités de correction (C, 2C, 4C...). La consigne F est ici numérique et chacun de ses bits met en ou hors circuit une capacité respective du réseau. Pour réaliser une variation de fréquence de repos proportionnelle à la consigne F, chacune des capacités du réseau a une valeur double de la précédente. Ces capacités n'étant que des capacités de correction, leurs valeurs sont faibles et elles sont généralement intégrables.

La consigne numérique F est fournie par un compteur 22 dont une entrée d'incrémentation est reliée à la sortie UPC d'une première porte ET 24 et dont une entrée de décrémentation est reliée à la sortie DOWNC d'une deuxième porte ET 25. La sortie d'un diviseur par N 27 est reliée à une première entrée de chacune des portes 24 et 25. La deuxième entrée de la porte 24 est reliée à la sortie UP du comparateur 10 par l'intermédiaire d'une bascule monostable 29. La deuxième entrée de la porte 25 est relié à la sortie DOWN du comparateur 10 par l'intermédiaire d'une bascule monostable 30. Les signaux de sortie des bascules 29 et 30 sont combinés dans une porte OU 32 avant d'être fournis à l'entrée du diviseur 27.

Avec cette configuration, le diviseur 27 reçoit un signal chaque fois qu'une impulsion est fournie par le comparateur 10, que ce soit une impulsion UP ou une impulsion DOWN, et génère une impulsion à sa sortie à chaque N^{ème} impulsion. Ainsi, à chaque N^{ème} impulsion, les portes 24 et 25 sont passantes. Cette N^{ème} impulsion est donc transmise par la porte 24 sur l'entrée d'incrémentation du compteur 22 s'il s'agit d'une impulsion UP ou par la porte 25 sur l'entrée de décrémentation s'il s'agit d'une impulsion DOWN. Une incrémentation du compteur 22 provoquera une augmentation de la fréquence de l'oscillateur 20 d'un pas fréquentiel et une décrémentation du compteur 22 provoquera la diminution de la fréquence de l'oscillateur 20 d'un pas fréquentiel. Le pas fréquentiel correspond à la variation de fréquence de l'oscillateur provoquée par la commutation de la plus petite des capacités du réseau de correction (C, 2C, 4C...).

Les bascules monostables 29 et 30 permettent de fournir au diviseur 27 et au compteur 22 des impulsions présentant une largeur suffisante pour assurer leur bon fonctionnement. Elles ne sont nécessaires que si les impulsions UP ou DOWN peuvent présenter des largeurs inférieures au temps de commutation des portes 24 et 25. En effet, de telles impulsions courtes risquent de ne pas être transmises vers le compteur 22.

Il s'agit maintenant de déterminer correctement la valeur N pour que chaque impulsion UP ou DOWN échantillonnée soit effectivement une impulsion modifiant le contenu du compteur 22 dans le bon sens.

On suppose que l'on se trouve à un instant t₀ dans la situation de la figure 4. A l'instant t₀, le signal Fvco est en avance de phase par rapport au signal Fext mais sa fréquence est inférieure. Si l'on n'agit pas sur le signal Fvco, celui-ci se trouvera dans une situation de retard de phase par rapport au signal Fext au bout d'un nombre prédéterminé d'impulsions. C'est au bout de ce nombre d'impulsions que les impulsions UP ou DOWN indiquent la bonne relation de fréquence entre les signaux Fext et Fvco. Ce nombre est égal au rapport entre l'écart de phase initial et la différence de période des signaux Fvco et Fext. Idéalement, le nombre N est égal à ce rapport. En pratique, le nombre N est choisi supérieur au rapport entre la fréquence nominale du signal Fext et le pas fréquentiel susmentionné.

Etant donné que la valeur du compteur 22 est modifiée à chaque N impulsions UP ou DOWN, même si les signaux Fext et Fvco sont synchronisés, il apparaît une ondulation résiduelle de la fréquence du signal Fvco de trois pas fréquentiels autour de la fréquence du signal Fext. Cette ondulation résiduelle est réduite à deux pas fréquentiels en doublant la valeur de N. Toutefois, en doublant la valeur de N, on réduit la rapidité de synchronisation. Pour réaliser un bon compromis entre la rapidité et la précision, le diviseur 27 est choisi programmable et initialement programmé à la valeur N. Un dispositif de détection de synchronisation classique, par exemple, provoquera ensuite une reprogrammation du diviseur à la valeur 2N.

La figure 6 représente l'allure de la réponse du signal Fvco à un échelon de fréquence du signal Fext. Avant un instant t₀, la fréquence des signaux Fext et Fvco est à une valeur initiale. A l'instant t₀, la fréquence du signal Fext prend une nouvelle valeur supérieure. Alors, la fréquence du signal Fvco tend toujours dans le bon sens par échelons vers la nouvelle valeur.

Dans le cas d'un glissement de phase, la fréquence du signal Fvco s'écarte au plus d'un pas fréquentiel de la fréquence initiale.

La boucle à verrouillage de fréquence selon l'invention se comporte de manière beaucoup plus stable que la boucle à verrouillage de phase classique de la figure 1 et elle tend continûment vers une synchronisation en fréquence quelle que soit la perturbation ou la situation au démarrage de la boucle.

La boucle à verrouillage de fréquence selon l'invention peut avantageusement être utilisée dans un téléviseur pour asservir la fréquence centrale d'un filtre de traitement du signal de chrominance (par exemple du filtre en cloche selon la norme SECAM). Ce genre de filtre doit être actif entre les retours trame et on peut envisager d'ajuster finement sa fréquence lors des retours trame. Pour cela, la fréquence du filtre est ajustée par un réseau de capacités de correction (C, 2C, 4C...) servant également à corriger la fréquence de l'oscillateur commandé de la boucle à verrouillage de fréquence. A chaque retour trame, la boucle à verrouillage de fréquence est activée et alimentée avec un signal Fext ayant pour fréquence la fréquence centrale que doit avoir le filtre (par exemple la sous-porteuse de chrominance SECAM de 4,250 MHz). Ainsi, pendant le retour trame, le réseau de capacités qui détermine la fréquence du filtre est convenablement ajusté pour que l'oscillateur commandé oscille à une fréquence la plus proche possible de celle du signal Fext. En pratique, dans une telle utilisation, on désire obtenir une précision de la fréquence du filtre de l'ordre de plus ou moins 7 kHz. Par conséquent, on choisit un pas fréquentiel de 7 kHz et un taux de division N de l'ordre de 700.

La présente invention est susceptible de nombreuses variantes et modifications qui apparaîtront à l'homme de l'art. Notamment, les diverses fonctions des circuits logiques décrits peuvent être réalisées de nombreuses autres manières. Par exemple, le diviseur 27 peut être réalisé à partir d'un décompteur dont l'état est réinitialisé à N à chaque N^{ème} impulsion ; les bascules monostables 29 et 30 sont alors de préférence présentes.

La présente invention a été décrite avec des circuits numériques mais si l'on ne souhaite pas intégrer tous les éléments, les fonctions des circuits numériques peuvent être réalisées par des circuits analogiques.

De même, le diviseur 27 peut être remplacé par une capacité de faible valeur (donc intégrable) qui est chargée d'une valeur constante à chaque impulsion UP ou DOWN. Lorsque la tension aux bornes de la capacité dépasse un seuil, l'impulsion UP ou DOWN survenant alors est transmise au compteur 22 et la capacité est en même temps déchargée.

## Revendications

1. Boucle à verrouillage de fréquence comprenant :
- un comparateur de phase (10) recevant en entrée des premier (Fext) et deuxième (Fvco) signaux périodiques et ayant une première sortie (UP) délivrant des impulsions si le premier signal (Fext) est en avance de phase par rapport au deuxième (Fvco) et une deuxième sortie (DOWN) délivrant des impulsions dans le cas inverse ;
- un oscillateur commandé en fréquence (20) délivrant le deuxième signal ; et
- un compteur (22) dont l'état fixe la fréquence de l'oscillateur et possédant une entrée d'incrémentation (+1) et une entrée de décrémentation (-1) ;
caractérisée en ce qu'elle comprend un circuit d'échantillonnage (24, 25, 27, 32) pour transmettre chaque N^{ème} desdites impulsions, N>1, soit vers l'entrée d'incrémentation si cette impulsion survient sur l'une des première et deuxième sorties du comparateur (10), soit vers l'entrée de décrémentation si cette impulsion survient sur l'autre des première et deuxième sorties du comparateur.

2. Boucle à verrouillage de fréquence selon la revendication 1, caractérisée en ce que la fréquence l'oscillateur (20) est variable par pas fréquentiels et en ce que le nombre N est choisi supérieur au rapport entre la fréquence nominale du premier signal (Fext) et un pas fréquentiel.

3. Boucle à verrouillage de fréquence selon la revendication 1, caractérisée en ce qu'elle comprend un diviseur (27) par N recevant en entrée lesdites impulsions (UP, DOWN) et commandant par sa sortie deux portes logiques (24, 25) dont les sorties sont respectivement reliées aux entrées d'incrémentation et de décrémentation du compteur (22) et recevant respectivement les impulsions de l'une et l'autre des première et deuxième sorties du comparateur (10).

4. Boucle à verrouillage de fréquence selon la revendication 3, caractérisée en ce que lesdites portes (24, 25) sont reliées au comparateur de phase (10) par l'intermédiaire de bascules monostables (29, 30).

5. Boucle à verrouillage de fréquence selon la revendication 3, caractérisée en ce que le diviseur (27) est un diviseur par un nombre N programmable.

6. Boucle à verrouillage de fréquence selon la revendication 1, caractérisée en ce que l'oscillateur (20) est un oscillateur à réseau de capacités (C, 2C, 4C...) dont chacune est mise hors ou en circuit par l'état d'un bit du compteur (22).

## Patentansprüche

1. Frequenzregelschleife, mit
einem Phasenkomparator (10), welcher erste (Fext) und zweite (Fvco) periodische Signale empfängt und einen ersten Ausgang (UP) aufweist, der Impulse vorsieht, wenn die Phase des ersten Signales (Fext) der des zweiten Signales (Fvxo) voreilt, sowie einen zweiten Ausgang (DOWN) aufweist, der im umgekehrten Fall Impulse vorsieht, einem frequenzgesteuerten Oszillator (20), der das zweite Signal vorsieht, und
einem Zähler (22), dessen Zustand die Frequenz des Oszillators bestimmt und der einen Inkrementeingang (+1) und einen Dekrementeingang (-1) aufweist,
**gekennzeichnet** durch eine Abtastschaltung (24, 25, 27, 32) zum Übertragen jedes N-ten Impulses, N>1, entweder zu dem Inkrementeingang, wenn der Impuls an einem, ersten oder zweiten Ausgang des Komparators auftritt, oder zu dem Dekrementeingang, wenn der Impuls an dem anderen, ersten oder zweiten Ausgang auftritt.

2. Frequenzregelschleife nach Anspruch 1, dadurch **gekennzeichnet**, daß die Frequenz des Oszillators (20) in Frequenzschritten variabel ist und daß die Zahl N so gewählt wird, daß sie größer ist als das Verhältnis zwischen der Nennfrequenz des ersten Signales (Fext) und einem Frequenzschritt.

3. Frequenzregelschleife nach Anspruch 1, dadurch **gekennzeichnet**, daß sie eine Einrichtung zum Teilen durch N (27) aufweist, welche die Impulse (UP, DOWN) empfängt und über ihren Ausgang zwei Logikgatter (24, 25) steuert, deren Ausgänge jeweils mit dem Inkrementeingang bzw. dem Dekrementeingang des Zählers (22) verbunden sind und welche jeweils Impulse von dem ersten bzw. dem zweiten Ausgang des Komparators (10) empfangen.

4. Frequenzregelschleife nach Anspruch 3, dadurch **gekennzeichnet,** daß die Gatter (24, 25) mit dem Phasenkomparator (10) über monostabile Flip-Flops (29, 30) verbunden sind.

5. Frequenzregelschleife nach Anspruch 3, dadurch **gekennzeichnet**, daß die Teilereinrichtung (27) eine Einrichtung zum Teilen durch eine programmierbare Zahl N ist.

6. Frequenzregelschleife nach Anspruch 1, dadurch **gekennzeichnet**, daß der Oszillator (20) eine Anordnung von Kondensatoren (C, 2C, 4C...) aufweist, von denen jeder abhängig von dem Zustand eines Bits des Zählers (22) angeschlossen oder nicht angeschlossen ist.

## Claims

1. A frequency locked loop including:
- a phase comparator (10) receiving first (Fext) and second (Fvco) periodic signals and having a first output (UP) providing pulses if the first signal (Fext) is in phase advance with respect to the second signal (Fvco) and a second output (DOWN) providing pulses in the opposite case;
- a frequency controlled oscillator (20) providing the second signal; and
- a counter (22), the state of which determines the frequency of the oscillator, having an incrementation input (+1) and a decrementation input (-1);
characterized in that it comprises a sampling circuit (24,25,27,32) for transmitting each Nth, N>1, of said pulses either to said incrementation input if the pulse occurs at one of the first and second outputs of the comparator, or to said decrementation input if the pulse occurs at the other of the first and second outputs.

2. A frequency locked loop according to claim 1, characterized in that the frequency of said oscillator (20) is variable by frequency steps and number N is chosen higher than the ratio between the nominal frequency of said first signal (Fext) and a frequency step.

3. A frequency locked loop according to claim 1, characterized in that it includes a divider by N (27) receiving said pulses (UP, DOWN) and controlling by its output two logic gates (24, 25), whose outputs are respectively connected to the incrementation and decrementation inputs of said counter (22) and respectively receiving pulses from both first and second outputs of said comparator (10).

4. A frequency locked loop according to claim 3, characterized in that said gates (24, 25) are connected to said phase comparator (10) through monostable flip-flops (29, 30).

5. A frequency locked loop according to claim 3, characterized in that said divider (27) is a divider by a programmable number N.

6. A frequency locked loop according to claim 1, characterized in that said oscillator (20) includes an array of capacitors (C, 2C, 4C...), each of which is connected or disconnected according to the state of a bit of said counter (22).
